# FASCICULE DE BREVET EUROPEEN

(11) **EP 3 073 180 B1**
(45) Date de publication et mention de la délivrance du brevet: **19.02.2020**
(21) Numéro de dépôt: 16160965.6
(22) Date de dépôt: 17.03.2016
(51) Int. Cl.: F21S 41/19, F21S 41/147, F21S 43/19, F21S 43/14, F21S 45/47

(54) **SUPPORT DE LED AVEC SURFACE DE RÉCEPTION ET CONNEXION ÉLECTRIQUE PAR PONTAGE**
LED-HALTERUNG MIT AUFNAHMEFLÄCHE UND ELEKTRISCHEM ANSCHLUSS DURCH ÜBERBRÜCKUNG
LED MOUNTING WITH RECEIVING SURFACE AND ELECTRICAL CONNECTION BY BRIDGING

(30) Priorité: 23.03.2015 FR 1552365
(43) Date de publication de la demande: 28.09.2016
(73) Titulaire: VALEO VISION, 93012 Bobigny Cedex (FR)
(72) Inventeur: ZOJCESKI, Zdravko, 92400 COURBEVOIE (FR); DUARTE, Marc, 93250 VILLEMOMBLE (FR); LAUVERNIER, Denis, 94400 VITRY SUR SEINE (FR)

(56) Documents cités:
- EP-A2- 2 306 078
- EP-A2- 2 327 582
- WO-A1-2006/072176
- WO-A1-2012/026058
- WO-A2-2007/107601
- JP-A- 2010 113 849
- JP-A- 2013 012 347
- US-A1- 2004 264 195
- US-A1- 2006 197 444

## Description

L'invention a trait au domaine de l'éclairage et/ou de la signalisation lumineuse, notamment pour véhicule automobile. Plus particulièrement, l'invention a trait au domaine du montage et de la connexion électrique de sources lumineuses du type diode électroluminescente, LED. L'invention a trait à un support pour source(s) lumineuse(s) et à un module comprenant un tel support.

L'utilisation de sources lumineuses du type diode électroluminescente dans les systèmes d'éclairage et/ou de signalisation lumineuse est de plus en plus répandue. Dans le domaine de l'éclairage et de la signalisation lumineuse automobile, des diodes dites de puissance sont utilisées. Ces dernières sont souvent généralement planes et du type à monter en surface. Le montage de composants en surface consiste à braser les composants d'une carte à sa surface (CMS ou SMD pour « surface mounted device » en anglais), plutôt que d'en faire passer les broches au travers. Les diodes lectroluminescentes étant des semiconducteurs, elles sont affectées par la température : plus elles chauffent, plus leur tension directe de jonction décroît, et leur rendement lumineux se dégrade. Pour des raisons de fiabilité et de performance lumineuse, des mesures de gestion thermique doivent être mises en œuvre, en particulier pour les modèles de puissance.

Le document de brevet publié FR 2 840 151 A1 divulgue un support de diode électroluminescente de puissance pour système d'éclairage ou de signalisation lumineuse pour véhicule automobile. La diode est collée sur un substrat métallique formant un radiateur. Ce substrat est fixé à une platine isolante électriquement. Il comprend deux échancrures s'étendant, chacune, et de manière opposée, depuis un bord de substrat jusqu'au bord de la diode. Une languette conductrice est disposée dans chacune des deux échancrures afin d'assurer une liaison électrique entre la diode et le circuit imprimé sur la platine, le substrat métallique assurant le refroidissement de la diode. Chacune des languettes est reliée par soudure à une des électrodes de la diode. La configuration de cet enseignement est intéressante dans la mesure où elle permet d'assurer un refroidissement de la diode tout en supportant celle-ci au moyen d'une platine isolante classique. La capacité de refroidissement est toutefois limitée, essentiellement en raison de la taille limitée du substrat métallique. De plus, la précision de positionnement est également limitée compte tenu de l'addition des tolérances de positionnement de la diode par rapport au substrat dissipateur, de ce dernier par rapport à la platine et ensuite de cette dernière par rapport au réflecteur ou au châssis du module d'éclairage ou de signalisation lumineuse.

Le document de brevet publié FR 2 853 200 A1 divulgue, similairement au document précédent, un support de diode électroluminescente de puissance pour système d'éclairage ou de signalisation lumineuse pour véhicule automobile. Similairement au document précédent, la diode est fixée à un substrat métallique apte à dissiper la chaleur produite par la diode. Ce substrat est fixé à une platine en matériau isolant électriquement et comprend deux échancrures opposées au travers desquelles s'étendent, respectivement, deux pattes ou languettes de connexion électrique. Alternativement au procédé de collage de la diode sur le substrat de dissipation thermique divulgué dans le document précédent, la diode de cet enseignement comprend une embase composée essentiellement de cuivre qui est fixée au substrat par soudure laser par points. Ces mesures sont destinées à éviter les inconvénients inhérents à l'utilisation de colle, à savoir le temps de séchage ou de réticulation, les moyens nécessaires à son application, le temps de son application et les moyens de maintien de la diode sur le substrat dissipateur jusqu'à ce que la colle assure sa fixation. Similairement au document précédent, la capacité de refroidissement dans cette construction est limitée, essentiellement en raison de la taille limitée du substrat métallique. Toujours similairement au document précédent, la précision de positionnement de la diode est limitée.

Le document JP 2010 113849 A divulgue un support de source lumineuse.

Il a également été proposé de disposer une platine comprenant un circuit d'alimentation d'électrique sur un substrat. Une ou plusieurs diodes électroluminescentes collées sur le même substrat généralement plan et étant apte à dissiper la chaleur produite par les diodes sont connectées au circuit d'alimentation par des liaisons de pontage. Dans ce cas il se pose le risque que les éléments du circuit ou la platine portent ombre sur une partie des sources lumineuses ou du moins sur le lieu géométrique de leur faisceau lumineux, en diminuant ainsi leur utilité.

L'invention a pour objectif de proposer un support de diode électroluminescente de puissance, notamment pour système d'éclairage ou de signalisation lumineuse pour véhicule automobile, qui pallie à au moins un des inconvénients présents dans les dispositifs connus de l'art antérieur.

L'invention a pour objet un support de source(s) lumineuse(s) pour module d'éclairage et/ou de signalisation lumineuse pour véhicule automobile selon la revendication 1. Le support comprend:
- un substrat matériau conducteur thermiquement, préférentiellement en matériau métallique, le substrat comprenant une base;
- au moins une source lumineuse à semi-conducteur;
- un circuit d'alimentation électrique de la ou des sources lumineuses supporté par le substrat;
- des moyens de connexion à un circuit d'alimentation électrique de la ou des sources lumineuses, les moyens de connexion étant reliés électriquement par pontage avec la ou les sources lumineuses au moyen de fils métalliques soudés en surface.

Le support est remarquable en ce que le substrat comprend au moins une structure qui fait saillie sur la base et qui définit une surface de réception sur laquelle au moins une des sources lumineuses est disposée en contact thermique.

La base du substrat peut de préférence avoir une forme généralement plane.

De préférence les sources lumineuses peuvent comprendre une diode électroluminescente, une diode électroluminescente de puissance ou une diode laser.

Avantageusement, les fils métalliques peuvent être constitués par un unique fil métallique de section cylindrique ou un languette métallique ou encore une tresse de fils métalliques.

De préférence, au moins une des surfaces de réception peut être généralement parallèle au plan du substrat.

Au moins une des surfaces de réception peut avantageusement être inclinée par rapport au plan du substrat.

Au moins une des surfaces de réception peut de préférence avoir une géométrie non-plane, par exemple une géométrie bombée.

Eventuellement, le support peut supporter plusieurs sources lumineuses. Le cas échéant, le substrat peut comporter plusieurs structures faisant saillie sur la base du substrat et définissant chacune une surface de réception sur laquelle au moins une des sources lumineuses est disposée en contact thermique. Avantageusement, les hauteurs respectives des structures par rapport à la base peuvent de préférence être différentes.

Le substrat peut de préférence comprendre une couche en surface électriquement isolante, sur laquelle le circuit d'alimentation est formé par des pistes métallisées électriquement conductrices.

Dans un mode de réalisation non couvert par les revendications, le substrat peut être en aluminium, la couche isolante étant formée par un procédé d'ionisation du substrat ou par un dépôt de polymère dopé en particules métalliques sur le substrat. Le cas échéant, les pistes métallisées peuvent être formées par une impression à l'aide d'une encre contenant des particules métalliques. Alternativement, les pistes peuvent être sont formées par un procédé de type dispositif d'interconnexion moulé, MID (« Molded Interconnect Device »).

Le circuit d'alimentation est imprimé sur ou dans une platine en matériau isolant électriquement disposée sur le substrat.

La platine peut de préférence être généralement plane, préférentiellement elle est en résine thermodurcissable renforcée de fibres solides.

De préférence, la platine peut être en matériau plastique moulé épousant la forme du substrat.

Alternativement, la platine peut être en matériau plastique flexible.

Encore alternativement, le circuit d'alimentation peut comprendre une grille de connexion. De préférence, la grille de connexion peut être déportée par rapport à la base du substrat.

Le substrat comprend deux faces opposées supportant chacune au moins une des sources lumineuses. Au moins une des deux faces comprend la au moins une structure qui fait saillie sur la base et qui définit une surface de réception supportant au moins une des sources lumineuses.

Le substrat comprend un orifice reliant les deux faces et disposé en face de la platine de manière à permettre la liaison électrique avec la ou les sources lumineuses sur la face du substrat opposée à celle sur laquelle est disposée la platine.

L'orifice peut de préférence être traversé par au moins un des fils métalliques reliés à la face de la platine en contact avec le substrat et à la ou une des diodes sur la face du substrat opposée à celle sur laquelle est disposée la platine.

Avantageusement, l'orifice peut être recouvert au moins partiellement par un revêtement en silicone ou en résine de polymère. Ce revêtement permet de tenir mécaniquement le fil métallique lors d'éventuelles vibrations.

La platine peut de préférence comprendre une portion s'étendant au travers de l'orifice, ladite portion comprenant au moins un contact électrique, un des fils métalliques s'étendant depuis ledit contact vers la ou une des sources lumineuses sur la face du substrat opposée à celle sur laquelle est disposée la platine.

De préférence, le substrat peut comprendre des ailettes de refroidissement.

Le substrat peut de préférence comprendre une première portion formant une paroi supportant la ou les sources lumineuses et une deuxième portion comprenant les ailettes de refroidissement.

La deuxième portion peut préférentiellement être disposée essentiellement dans l'alignement de la première portion.

Avantageusement, les première et deuxième portions du substrat peuvent être venues de matière.

De préférence, la ou les sources lumineuses peuvent être collées sur le substrat. La ou les structures en saillie et le substrat peuvent avantageusement être venus de matière.

Les connexions par pontage peuvent préférentiellement être réalisées par des fils métalliques en un matériau choisi parmi l'aluminium, le cuivre, l'or et l'argent, les fils étant soudés à chaque extrémité à des plots de connexion ayant au moins en surface une couche métallique dans le même matériau.

L'invention a également pour objet un support de source(s) lumineuse(s) pour un module d'éclairage et/ou de signalisation lumineuse pour véhicule automobile, comprenant un substrat, au moins une source lumineuse connectée électriquement à un premier plot de connexion, un circuit d'alimentation connecté électriquement à un deuxième plot de connexion, la source lumineuse étant reliée électriquement au circuit d'alimentation par pontage au moyen d'un fil métallique reliant le premier plot au deuxième plot.

De préférence le fil métallique peut être soudé par ses extrémités aux plots de connexion, préférentiellement par ultrasons

Les plots de connexion peuvent de préférence comprendre au moins en surface une couche du même métal (or, cuivre, argent ou aluminium) utilisé pour les fils soudés. Ceci permet des connexions à efficacité et durabilité accrues.

Le matériau du fil peut être est de l'aluminium, de l'or ou du cuivre. Le diamètre du fil peut être compris entre 75µm et 250µm.

L'invention a également pour objet un procédé destiné à rendre la technologie du pontage compatible avec des plots de connexion, comprenant par exemple du cuivre. Le procédé comprend les étapes suivantes :
- mise à disposition d'un plot de connexion comprenant une feuille qui contient du cuivre, ou un alliage de cuivre et d'acier, la feuille ayant préférentiellement une épaisseur d'environ 0.2 mm à 0.8 mm, la feuille étant couverte sur sa face inférieure, qui est utilisée lors du soudage et qui contacte le circuit imprimé, d'une couche mince d'étain Sn, la couche mince ayant de préférence une épaisseur d'environ 25 micromètres;
- couverture de la face supérieure du plot de connexion d'une couche d'aluminium, si des fils en aluminium sont utilisés pour réaliser le pontage, la couche ayant de préférence une épaisseur d'environ 3.8 micromètres à 10 micromètres ;
- soudage du fils de pontage plot de connexion ainsi préparé.

Alternativement, la couche de la face supérieure peut être en nickel, ou en nickel-phosphore.

Si les fils de pontage sont en or ou en argent ou en cuivre, la couche en surface peut de préférence être choisie en adéquation dans le même matériau.

De préférence, chaque plot de connexion peut avoir une surface quadratique de 1.8 x 1.8 mm.

Cette méthode de connexion par pontage est généralement applicable à tous types de liaisons électriques par pontage sur tous supports et présente l'avantage de rendre la technologie du pontage compatible avec une pluralité de circuits imprimés, par exemple des circuits imprimés flexibles.

L'invention a également pour objet un module d'éclairage pour véhicule automobile, comprenant :
- un support de source(s) lumineuse(s);
- au moins un dispositif optique apte à dévier les rayons lumineux émis par la ou au moins une des sources lumineuses en un faisceau d'éclairage.

Le module est remarquable en ce que le support est conforme à l'invention.

De préférence, le dispositif optique comporte un réflecteur.

De préférence, le module peut comprendre un premier réflecteur disposé en regard d'une des deux faces du substrat, ladite face supportant au moins une des sources lumineuses et un deuxième réflecteur disposé en regard de l'autre desdites deux faces, ladite autre face supportant au moins une des sources lumineuses.

Le substrat peut de préférence comprendre des ailettes de refroidissement disposées en arrière du ou des réflecteurs par rapport à la direction principale du faisceau d'éclairage.

Les mesures de l'invention sont intéressantes en ce qu'elles permettent de réaliser le positionnement des sources lumineuses avec une grande précision directement sur le substrat servant de châssis et de pièce de référence. Le refroidissement des sources lumineuses est également optimisé. Le ou les circuits d'alimentation électrique peut/peuvent être positionné(s) et fixé(s) avec moins de précision que les sources lumineuses, notamment en proportion de la taille de leurs zones de contact avec les fils métalliques.

Les structures en saillie sur le support et définissant des plans ou surfaces de réception pour les sources lumineuses permettent de donner à celles-ci une orientation spécifique sans nécessiter d'autres composants. Notamment les sources sont élevées par rapport au circuit d'alimentation afin d'éviter tout risque d'ombre portée de la part de ce dernier.

La technologie de connexion par pontage avec des fils métalliques soudés, préférentiellement par ultrasons, permet de réaliser ensuite les connexions électriques de manière simple, fiable, économique et compatible avec la liaison avec colle des sources lumineuses. L'utilisation de plots de connexion ayant au moins en surface une couche du même métal (or, cuivre, argent ou aluminium) utilisé pour les fils soudés permet des connexions à efficacité et durabilité accrues. En particulier, la mise à disposition d'un plot de connexion à surface en or, cuivre, argent ou aluminium permet d'utiliser la technique du pontage (« wire-bonding ») sur des circuits imprimés flexibles présentant en général une couche de cuivre en surface. En variante, la connexion peut être réalisée via un plot de connexion en Nickel ou en un alliage de type Nickel-Phosphore.

D'autres caractéristiques et avantages de la présente invention seront mieux compris à l'aide de la description et des dessins parmi lesquels:
- la figure 1 est une vue en perspective d'un support de diodes électroluminescentes ou laser, conforme à un premier mode de réalisation de l'invention, la vue montrant la face supérieure dudit support ;
- la figure 2 est une vue en perspective du support de la figure 1, la vue montrant toutefois la face inférieure dudit support ;
- la figure 3 est une vue en coupe d'un support de diodes électroluminescentes ou laser, conforme à un deuxième mode de réalisation de l'invention ;
- la figure 4 est une vue en coupe d'une partie de support de diodes électroluminescentes ou laser, conforme à un troisième mode de réalisation de l'invention, la partie non représentée étant similaire au support de la figure 3 ;
- la figure 5 est une vue en coupe d'une partie de support de diodes électroluminescentes ou laser, conforme à un quatrième mode de réalisation de l'invention, la partie non représentée étant similaire au support de la figure 3.

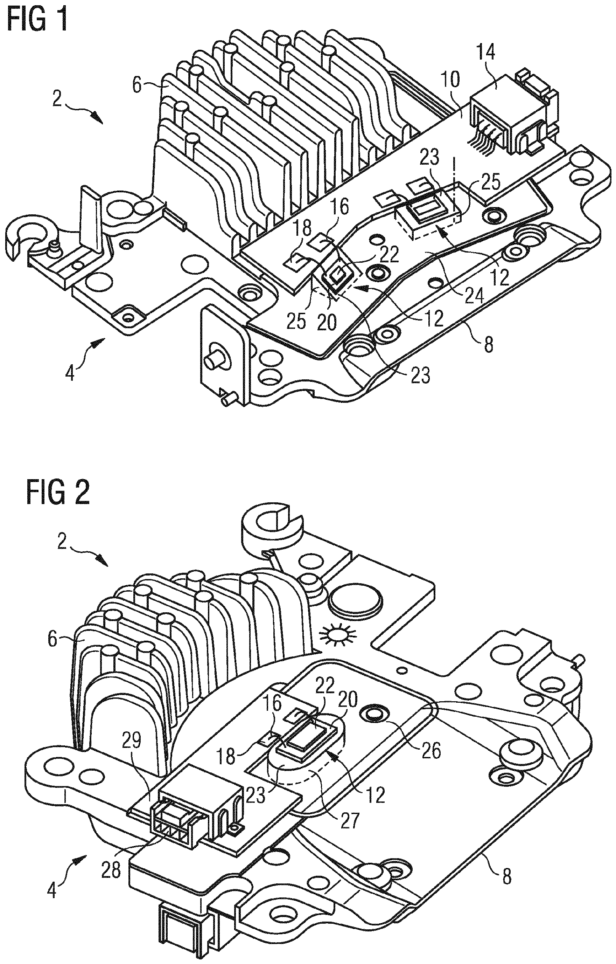

Les figures 1 et 2 illustrent un premier mode de réalisation de l'invention. La figure 1 est une vue en perspective de la face supérieure d'un support de sources lumineuses du type diode électroluminescente. Le support 2 comprend, essentiellement, un substrat 4 supportant des diodes électroluminescentes 12. Plus précisément le substrat en matériau conducteur thermiquement, comme par exemple de l'aluminium, comprend une base ou première portion 8 généralement mince et plate et une deuxième portion 6 formant des ailettes de refroidissement. Les première et deuxième portions sont préférentiellement unitaires, plus préférentiellement venues de matière. Les ailettes 6 peuvent s'étendre dans une direction généralement transversale, préférentiellement perpendiculaire, au plan moyen de la première portion.

La face supérieure 24 de la première portion 8 comprend une ou plusieurs structures 25 en saillie par rapport à la base généralement plane. Chaque structure 25 définit un plan de réception ou de support, qui supporte dans l'exemple montré chacun une diode électroluminescente 12. Il s'agit de diodes de puissance, c'est-à-dire de puissance supérieure ou égale à 3 Watt, aptes à être fixées par leur base. Elles comprennent une embase 20 et une portion optique 22 sur ladite embase 20. L'embase des diodes est fixée à la surface 23 du substrat 8 au moyen de colle thermique, c'est-à-dire au moyen d'une colle présentant des propriétés de transmission de chaleur. Il peut s'agir d'une colle de la société Epotek®. La géométrie des structures 25 peut être choisie en déviant de l'exemple montré par la figure 1. La figure 1 montre deux structures 25. Une première structure définit une surface de réception rectangulaire dans un plan parallèle à l'élément de base du substrat, mais en élévation par rapport à celui-ci, tandis qu'une deuxième structure définit un plan de réception 23 incliné par rapport à l'élément de base. Chaque structure 25 ou piédestal peut être choisie de façon à présenter une surface de réception apte à supporter plusieurs sources lumineuses 12 sans pour autant sortir du cadre de l'invention. Idéalement, les structures 25 sont venues de matière thermiquement conductrice avec la base du substrat 4, de façon à optimiser la dissipation de la chaleur engendrée par les sources lumineuses supportées. La surface 23 est suffisamment plane et a une aire suffisamment importante pour pouvoir recevoir au moins un source lumineuse 12.

Une platine 10 recouverte d'un circuit électrique imprimé (non représenté) est disposée également sur la première portion 8 essentiellement plate du substrat 4. La platine présente un profil se conformant aux diodes 12 de manière à les longer à une distance inférieure à 10mm, préférentiellement 5mm. Un connecteur 14 est disposé sur la platine de manière à permettre son alimentation via un câble flexible (non représenté). Des zones ou plots de contact 18 sont prévus sur la platine 10 en vis-à-vis des diodes 12, ces contacts étant électriquement reliés au circuit imprimé. Les diodes 12 sont reliés électriquement au circuit d'alimentation de la platine 10 via des fils métalliques 16 formant des ponts entre les zones de contact 18 de la platine et les zones de contact correspondantes des diodes. Ces fils 16 sont soudés à ces zones par ultrasons. Il s'agit de la technologie communément désignée par l'expression anglo-saxonne «wire-bonding », ou encore par l'expression « câblage par fil » ou « pontage ». C'est une technique couramment utilisée pour effectuer les connexions électriques entre le boîtier et la puce d'un circuit intégré. Le câblage est simplement réalisé par un fil (ou pont) soudé entre les deux plots de connexion prévus à cet usage sur chacun des éléments. La soudure est généralement réalisée par ultrasons. Le matériau du fil est de l'aluminium, de l'or ou du cuivre. Le diamètre du fil peut être compris entre 75µm et 250µm.

Dans le cas de l'utilisation de l'invention dans un dispositif lumineux d'un véhicule automobile, le circuit d'alimentation électrique sert par exemple à convertir une tension fournie par une batterie du véhicule automobile, en une tension de charge apte à alimenter la ou les sources lumineuses reliées au circuit d'alimentation. De tels circuits sont en soi connus dans l'art et ne seront pas décrits en plus de détails dans le cadre de la présente invention.

La figure 2 est une vue de la face inférieure du support 2 de la figure 1. Similairement à la face supérieure, la face inférieure 26 de la portion généralement mince et plate 8 du substrat 4 supporte une diode 12, cette diode pouvant être similaire ou identique à celles situées sur la face supérieure de ladite portion 8 du substrat 4. La diode 12 est fixée également par collage au moyen d'une colle thermique sur une surface de réception 23 d'une structure 27 faisant saillie sur le substrat 4, montrée à titre exemplaire sous forme elliptique. La surface de réception 23 permet d'une part, par son élévation par rapport à la base 8, de mitiger le risque que la diode ne reçoive des ombres portées par des éléments avoisinants. D'autre part l'orientation d'une telle surface de réception 23 permet de donner une orientation à la lumière émise par la diode. Une platine 29 est également fixée sur la face inférieure de la portion 8 du substrat 4, cette platine comprenant un circuit préférentiellement imprimé (non représenté) et destiné à alimenter électriquement la diode 12. Des zones ou plots de contact 18 similaires à celles de la platine 10 de la face inférieure sont également prévus. La liaison électrique entre le circuit de la platine 29 et la diode 12 est également assurée par des fils soudés 16 formant un pontage. La platine 29 comprend un connecteur 28 destiné à permettre son alimentation à partir d'un câble souple (non représenté).

Pour les deux faces 24 et 26, les fils 16 de la liaison électrique s'étendent de manière généralement courbée à distance des surfaces extérieures des diodes et de la platine. Cette technique de liaison consiste à appliquer une première extrémité d'un fil métallique en contact avec une zone ou plot de contact de l'un de la diode et de la platine, et ensuite d'y appliquer des ultrasons afin de l'y souder. Après soudure, le fil peut ensuite être déroulé depuis un outil pour ensuite être coupé et appliqué sur la deuxième des deux zones de contact à relier électriquement. Ces fils sont ainsi rigidement fixés à leurs extrémités aux zones de contact respectives, ces liaisons rigides assurant le maintien du reste du fil dans sa position telle que visible aux figures 1 et 2.

D'un point de vue procédé et méthode d'assemblage, les diodes 12 sont mises en place directement sur les surfaces de réception 23 du substrat 4 de manière précise, évitant tout cumul de tolérances, notamment lorsqu'elles sont sur un support qui est lui-même positionné sur une platine qui est elle-même positionnée sur le substrat faisant office de pièce de référence. En effet, le substrat comprend des moyens de fixation sur un boîtier (non représenté) et est destiné à recevoir les réflecteurs coopérant avec les diodes. La précision de positionnement peut atteindre une tolérance jusqu'à 30µm. La ou les platines peuvent être mises en place avant ou après la mise en place de la ou des diodes correspondantes. L'opération de pose des fils métalliques de pontage est réalisée après que la ou les diodes et que la ou les platines soient mises en place.

Le support 2 illustré aux figures 1 et 2 est destiné à former un module d'éclairage bi-fonction. Les diodes de la face supérieure 24 assurent une première fonction d'éclairage à coupure horizontale du type feux de croisement ou encore « code ». La diode de la face inférieure 26 forme un faisceau en complément de celui de la première fonction, formant ainsi une deuxième fonction dite d'éclairage route, c'est-à-dire sans coupure horizontale. Un réflecteur est de profil parabolique et en forme de demi-coquille est destiné à être disposé sur chacune de deux faces de la portion mince et essentiellement plane 8 du substrat 4. Le substrat 4 forme ainsi le châssis du module d'éclairage.

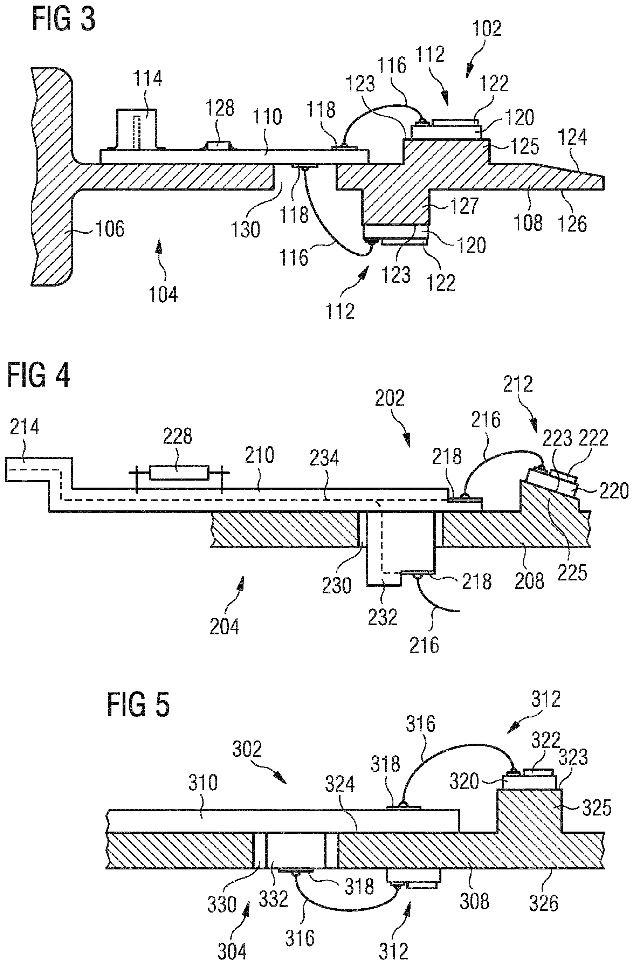

La figure 3 illustre un deuxième mode de réalisation de l'invention. Elle est une vue en coupe longitudinale d'un support de diode similaire à celui du premier mode de réalisation. Les numéros de référence du premier mode de réalisation sont utilisés dans le deuxième mode de réalisation pour les éléments identiques ou similaires, ces numéros étant majorés de 100 afin de bien distinguer les deux modes. Il est par ailleurs fait référence pour ces éléments à la description correspondante du premier mode. Des numéros spécifiques compris entre 100 et 200 ont été utilisés pour les éléments spécifiques.

Le module 102 comprend un substrat 104 comprenant, similairement à celui des figures 1 et 2, une première portion 108 généralement mince et plate et une deuxième portion 106 formant des ailettes de refroidissement. Ce mode de réalisation se distingue du premier en ce que le support 102 ne comprend qu'une seule platine d'alimentation 110. Cette dernière s'étend le long de la face supérieure de la portion 108 du substrat 104, au dessus d'un orifice 130 traversant ladite portion 108. La diode 112 disposée sur la face inférieure est supportée par un piédestal 127 en élévation (montrée vers le bas) par rapport à la base 108 généralement plane du substrat 104. Cette diode 112 est reliée électriquement à la platine 110 sur la face supérieure au moyen de fils soudés 116 du type pontage s'étendant depuis la diode 112 au travers de l'orifice 130 jusqu'à des zones de contact 118 sur la face inférieure de la platine 110 en vis-à-vis de l'orifice 130. La ou les diodes sur la face supérieure sont reliées également via des fils métalliques soudés 116, similairement au premier mode de réalisation des figures 1 et 2.

Le diamètre de l'orifice 130 est dimensionné pour permettre une mise en œuvre aisée des fils métalliques soudés 116. Il peut être supérieur à 5mm, préférentiellement 10mm.

Ce deuxième mode de réalisation permet de diminuer le nombre nécessaire de platine(s) d'alimentation, plus particulièrement de ne requérir qu'une seule platine pour deux faces d'un substrat, ce qui est particulièrement avantageux.

La figure 4 illustre un troisième mode de réalisation de l'invention. Elle est une vue en coupe longitudinale d'un support de diode, similairement à la figure 3 du deuxième mode de réalisation. La vue en coupe est toutefois partielle, le reste du support non représenté étant similaire à celui de la figure 3. Les numéros de référence du deuxième mode de réalisation sont utilisés dans le troisième mode de réalisation pour les éléments identiques ou similaires, ces numéros étant majorés de 100 afin de bien distinguer les deux modes. Il est par ailleurs fait référence pour ces éléments à la description correspondante du premier mode. Des numéros spécifiques compris entre 200 et 300 ont été utilisés pour les éléments spécifiques.

La platine 210 au lieu d'être essentiellement plane comme dans les deux premiers modes de réalisation de l'invention, est en fait un élément en plastique moulé dont la forme se conforme à celle du substrat 204. Le circuit électrique 234 peut par ailleurs être noyé à l'intérieur de la platine 210 ou encore être imprimé ou déposé sur sa surface extérieure. Un connecteur 214 peut être moulé directement avec le reste de la platine, dans la masse de son matériau. Des composants 228 peuvent être prévus, notamment à l'extérieur de la platine afin de permettre leur remplacement ou leur sélection en fonction de divers paramètres de fonctionnement. La platine 210 comprend une portion 232 faisant saillie de sa face intérieure et traversant l'orifice 230. Le circuit électrique 234 peut alors s'étendre au travers de l'orifice 230 à l'intérieur de la matière plastique de la platine 210, plus précisément de la portion en en saillie 232, jusqu'à terminer à une zone de contact 218 en vue d'assurer une connexion électrique avec la diode de la face correspondante. Le matériau plastique utilisé pour la platine 210 est préférentiellement un matériau thermoplastique. Il peut également être renforcé de fibres. Une source lumineuse 212 est montrée collée sur une structure 225 faisant saillie sur l'élément de base 208 du substrat, et définissant un plan de réception 223 incliné par rapport à celui-ci.

La figure 5 illustre un quatrième mode de réalisation de l'invention. Elle est une vue en coupe longitudinale d'un support de diode, similairement aux figures 3 et 4 des deuxième et troisième modes de réalisation, respectivement. La vue en coupe est toutefois partielle, le reste du support non représenté étant similaire à celui de la figure 3. Les numéros de référence du troisième mode de réalisation sont utilisés dans le quatrième mode de réalisation pour les éléments identiques ou similaires, ces numéros étant majorés de 100 afin de bien distinguer les deux modes.

La platine 310 est de construction similaire à la platine 110 du deuxième mode de réalisation à la figure 3, à cette différence près qu'elle comprend un ajout 332 sur sa face intérieure et traversant l'orifice 330 de la portion mince et généralement plate 308 du substrat 304. Cet ajout peut être collé sur la face intérieure de la platine 310, cette dernière étant réalisée classiquement en résine époxy renforcée de fibres. L'élément d'ajout 332 est préférentiellement en matériau isolant électriquement, comme par exemple un matériau plastique. Il convient alors de prévoir une liaison électrique entre le circuit imprimé sur la face extérieure de la platine 310 et la zone de contact 318 sur la face extérieure de l'élément ajouté 332. L'élément d'ajout 332 peut également être en matériau conducteur électriquement, par exemple en matériau métallique. Dans ce cas, cet élément doit présenter une taille inférieure à celle de l'orifice 330 afin d'éviter tout contact électrique. Un isolant sur sa face extérieure en vis-à-vis de la surface intérieure de l'orifice peut être prévu. La liaison électrique entre la ou les diodes et l'élément d'ajout 332 est similaire à celle des modes de réalisation précédents. Il en va de même pour la liaison électrique entre la ou les diodes de la face opposée et la platine 310. A titre exemplaire une première source lumineuse 312 est montrée collée sur un structure 325 faisant saillie sur la première surface 324 de l'élément de base 308 du substrat, et définissant un plan de réception 323 en élévation par rapport à celui-ci. Une deuxième source lumineuse est montrée collée directement sur la deuxième surface 326 opposée de de l'élément de base 308 su substrat 304.

Dans un autre mode de réalisation avantageux, le circuit d'alimentation selon l'invention peut être disposé sur un circuit imprimé flexible, FPCB (en anglais : « flexible printed circuit board », FPCB). De tels composants sont en soi connus dans l'art. Ils comprennent en général un film flexible en matière polymère, par exemple en polyamides, recouvert d'une couche mince de cuivre, par exemple d'épaisseur de 15µm à 35µm. Un circuit est imprimé par des procédés de lithographie en soi connus dans l'art. L'utilisation d'un FPCB dans le contexte de l'invention présente l'avantage de permettre une utilisation plus flexible de l'espace prévu pour monter le circuit d'alimentation. Cependant, la connexion électrique par pontage (« wire-bonding ») et soudage ultrason d'un FPCB à une diode électroluminescente ou laser peut poser problème. Afin de rendre la technologie du pontage compatible il est avantageux de préparer les zones ou plots de connexion 18, 118, 218, 318 aux deux extrémités de la liaison de pontage comme suit. Une feuille comprenant du cuivre (ou un alliage de cuivre et d'acier)d'une épaisseur d'environ 0.2 mm à 0.8 mm est couverte sur sa face inférieure, qui est utilisée lors du soudage et qui contacte le circuit imprimé, d'une couche mince d'étain Sn, d'une épaisseur d'environ 25 micromètres.La face supérieure du plot de connexion est couverte d'une couche d'aluminium ou de nickel voir de nickel-phosphore si des fils en aluminium sont utilisés pour réaliser le pontage. Cette couche en surface a une épaisseur allant d'environ 3.8 à 10 micromètres. Si les fils de pontage sont en or ou en argent ou en cuivre, la couche en surface du plot est choisie en adéquation dans le même matériau. Idéalement le plot de connexion s'étend sur une surface quadratique de 1.8 x 1.8 mm. Une fois le plot ainsi préparé, le fils de pontage y est soudé, de préférence par soudage ultrason. Cette méthode de connexion par pontage est généralement applicable à tous types de liaisons électriques par pontage sur tous supports.

Dans encore un autre mode de réalisation, le circuit d'alimentation est directement disposé sur une surface du substrat, sans l'utilisation d'un support spécifique tel qu'une platine. De préférence, la surface du substrat, ou tout le substrat, est en aluminium anodisé. Une partie de la surface est couverte d'une résine acrylique électriquement isolante dopée en particules métalliques aptes à assurer l'accrochage de pistes électriques en matériau métallique sur sa surface extérieure.

Des pistes électriques peuvent être réalisées par la technologie désignée par l'acronyme LDS signifiant en langue anglaise « Laser Direct Structuring ». Il s'agit de faire parcourir un rayon laser sur la surface correspondante du substrat, suivant la configuration des pistes à réaliser. Le rayon laser a pour effet de former une rugosité apte à favoriser l'accrochage. Cette étape est suivie d'une métallisation par trempage du substrat dans un ou plusieurs bains métalliques successifs.

Alternativement ou de manière complémentaire, des pistes électriques peuvent être réalisées directement sur la surface anodisé du substrat par impression du type jet d'encre dont l'encre comprend des particules métalliques.

Alternativement ou de manière complémentaire, des pistes électriques peuvent être réalisées directement sur la surface anodisé du substrat par impression du type jet d'encre sur une feuille fine PET ou PEN qui sera par la suite déposée sur le support par thermoformage.

Dans tous les modes de réalisation décrits, les surfaces de réception 23, 123, 223, 323 peuvent être utilisées pour supporter des montages électroniques plus complexes au lieu de supporter uniquement une source lumineuse de type diode électroluminescente ou diode laser. Par exemple, un tel sous-montage relié par pontage au circuit d'alimentation peut comprendre d'autres composants électroniques, notamment des capacités céramiques, des thermisteurs ou des circuit intégrés, en dépendance de la fonctionnalité visée.

De manière générale, il est entendu que la description qui vient d'être faite des différents modes de réalisation est également valable dans le cas d'une inversion des faces supérieure et inférieure. Des caractéristiques techniques montrées ou décrites pour un mode réalisation spécifique peuvent être appliquées à d'autres modes décrits sauf indication contraire explicite.

Toujours de manière générale, il est à noter que le nombre de diodes représentées sur les faces supérieure et inférieure de la portion du substrat des différents modes de réalisation décrits ci-avant est purement exemplatif, ce nombre pouvant varier. Chacune des faces peut ainsi comprendre une, deux ou plus de deux diodes conformément aux dispositions de ces figures.

## Revendications

1. Support (2; 102 ; 202 ; 302) de source(s) lumineuse(s) pour module d'éclairage et/ou de signalisation lumineuse pour véhicule automobile, comprenant :
- un substrat (4 ; 104 ; 204, 304) en matériau conducteur thermiquement, préférentiellement en matériau métallique, le substrat comprenant une base (8 ; 108 ; 208 ; 308) ;
- au moins une source lumineuse (12 ; 112 ; 212 ; 312) à semi-conducteur ;
- un circuit d'alimentation électrique de la ou des sources lumineuses supporté par le substrat ;
- des moyens de connexion (18 ; 118 ; 218 ; 318) audit circuit d'alimentation électrique (10, 29 ; 110 ; 210 ; 310) de la ou des sources lumineuses, les moyens de connexion étant reliés électriquement par pontage avec la ou les sources lumineuses (12, 112 ; 212 ; 312) au moyen de fils métalliques soudés en surface (16 ; 116 ; 216 ; 316);
le substrat comprenant au moins une structure (25 ; 125 ; 225 ; 325) qui fait saillie sur la base (8 ; 108 ; 208 ; 308) et qui définit une surface de réception (23 ; 123 ; 223 ; 323) sur laquelle au moins une des sources lumineuses est disposée en contact thermique ;
dans lequel les sources sont élevées par rapport au circuit d'alimentation afin d'éviter tout risque d'ombre portée de la part de ce dernier, dans lequel le circuit d'alimentation est imprimé sur ou dans une platine (10, 29 ; 110 ; 210 ; 310) en matériau isolant électriquement disposée sur le substrat (4 ; 104 ; 204 ; 304), le substrat (104 ; 204 ; 304) comprenant deux faces opposées, au moins une des deux faces comprenant la au moins une structure (25 ; 125 ; 225 ; 325, 27 ; 127) qui fait saillie sur la base et qui définit une surface de réception (23 ; 123 ; 223 ; 323) supportant au moins une des sources lumineuses (112 ; 212 ; 312), le substrat comprenant un orifice (130 ; 230, 330) reliant les deux faces et disposé en face de la platine (110 ; 210 ; 310), **caractérisé en ce que** les deux faces opposées du substrat supportent chacune au moins une des sources lumineuses, et **en ce que** l'orifice (130, 230, 330) est disposé en face de la platine de manière à permettre la liaison électrique avec la ou les sources lumineuses sur la face du substrat opposée à celle sur laquelle est disposée la platine.

2. Support (2 ; 102 ; 202 ; 302) selon la revendication 1, **caractérisé en ce que** au moins une des surfaces de réception (23 ; 123 ; 223 ; 323) est généralement parallèle au plan du substrat (4 ; 104 ; 204 ; 304).

3. Support (2 ; 102 ; 202 ; 302) selon une des revendications 1 ou 2, **caractérisé en ce que** au moins une des surfaces de réception (23 ; 123 ; 223 ; 323) est inclinée par rapport au plan du substrat (4 ; 104 ; 204 ; 304).

4. Support (2 ; 102 ; 202 ; 302) selon l'une des revendications 1 à 3, **caractérisé en ce que** le substrat comprend une couche en surface électriquement isolante, sur laquelle le circuit d'alimentation est formé par des pistes métallisées électriquement conductrices.

5. Support (102) selon l'une des revendications 1 à 4, **caractérisé en ce que** l'orifice (130) est traversé par au moins un des fils métalliques (116) relié à la face de la platine (110) en contact avec le substrat (104) et à la ou une des diodes (112) sur la face du substrat (104) opposée à celle sur laquelle est disposée la platine (110).

6. Support (202 ; 302) selon l'une des revendications 1 à 4, **caractérisé en ce que** la platine (210 ; 310) comprend une portion (232 ; 332) s'étendant au travers de l'orifice (230 ; 330), ladite portion comprenant au moins un contact électrique (218 ; 318), un des fils métalliques (216 ; 316) s'étendant depuis ledit contact vers la ou une des sources lumineuses (212 ; 312) sur la face du substrat (204 ; 304) opposée à celle sur laquelle est disposée la platine (210 ; 310).

7. Support (2 ; 102 ; 202 ; 302) selon l'une des revendications 1 à 6, **caractérisé en ce que** le substrat (4; 104 ; 204 ; 304) comprend des ailettes de refroidissement (6 ; 106 ; 206 ; 306).

8. Support (2 ; 102 ; 202 ; 302) selon la revendication 7, **caractérisé en ce que** le substrat (4 ; 104 ; 204 ; 304) comprend une première portion (8 ; 108 ; 208 ; 308) formant une paroi supportant la ou les sources lumineuses et une deuxième portion (6 ; 106 ; 206 ; 306) comprenant les ailettes de refroidissement.

9. Support (2 ; 102 ; 202 ; 302) selon l'une des revendications 1 à 8, **caractérisé en ce que** la ou les sources lumineuses (12 ; 112 ; 212 ; 312) sont collées sur le substrat (4 ; 104 ; 204 ; 304).

10. Module d'éclairage pour véhicule automobile, comprenant :
- un support (2 ; 102 ; 202 ; 302) de source(s) lumineuse(s) (12 ; 112 ; 212 ; 312) ;
- au moins un dispositif optique apte à dévier les rayons lumineux émis par la ou au moins une des sources lumineuses en un faisceau d'éclairage ;
**caractérisé en ce que**
le support est conforme à l'une des revendications 1 à 9.

11. Module d'éclairage selon la revendication 10, **caractérisé en ce qu'**il comprend un premier réflecteur disposé en regard d'une des deux faces du substrat (4 ; 104 ; 204 ; 304), ladite face supportant au moins une des sources lumineuses et un deuxième réflecteur disposé en regard de l'autre desdites deux faces, ladite autre face supportant au moins une des sources lumineuses.

12. Module d'éclairage selon l'une des revendications 10 et 11, **caractérisé en ce que** le substrat (4 ; 104 ; 204 ; 304) comprend des ailettes de refroidissement (6 ; 106 ; 206 ; 306) disposées en arrière du ou des réflecteurs par rapport à la direction principale du faisceau d'éclairage.

## Patentansprüche

1. Lichtquellenhalter (2; 102; 202; 302) für Lichtquelle(n) für ein Beleuchtungs- und/oder Lichtsignalisierungsmodul für ein Kraftfahrzeug, mit :
- ein Substrat (4; 104; 204, 304) aus wärmeleitendem Material, vorzugsweise aus metallischem Material, wobei das Substrat eine Basis (8; 108; 208; 308) aufweist;
- mindestens eine Halbleiter-Lichtquelle (12; 112; 212; 312);
- eine Stromversorgungsschaltung für die vom Substrat getragene(n) Lichtquelle(n) ;
- Verbindungsmittel (18; 118; 218; 318) zu der Stromversorgungsschaltung (10, 29; 110; 210; 310) der Lichtquelle(n), wobei die Verbindungsmittel mit der/den Lichtquelle(n) (12, 112; 212; 312) mittels oberflächengeschweißter Metalldrähte (16; 116; 216; 316) elektrisch überbrückt sind;
wobei das Substrat mindestens eine Struktur (25; 125; 225; 325) umfasst, die von der Basis (8; 108; 208; 308) vorsteht und die eine Empfangsfläche (23; 123; 223; 323) definiert, auf der mindestens eine der Lichtquellen in thermischem Kontakt angeordnet ist;
bei denen die Quellen im Verhältnis zum Stromkreis hoch liegen, um die Gefahr von Schattenwürfen durch den Stromkreis zu vermeiden,
wobei die Stromversorgungsschaltung auf oder in einer Platte (10, 29; 110; 210; 310) aus elektrisch isolierendem Material gedruckt ist, die auf dem Substrat (4; 104; 204; 304) angeordnet ist, wobei das Substrat (104; 204; 304) zwei gegenüberliegende Seiten aufweist, wobei mindestens eine der beiden Seiten die mindestens eine Struktur (25; 104; 204; 304) aufweist; 125; 225; 325; 27; 127), die von der Basis vorspringt und die eine Empfangsfläche (23; 123; 223; 323) definiert, die mindestens eine der Lichtquellen (112; 212; 312) trägt, wobei das Substrat eine Öffnung (13a; 230; 330) aufweist, die die beiden Seiten verbindet und gegenüber der Platte (110; 210; 310) angeordnet ist,
**dadurch gekennzeichnet, dass** die beiden gegenüberliegenden Seiten des Substrats jeweils mindestens eine der Lichtquellen tragen, und dass die Öffnung (130, 230, 330) gegenüber der Platte so angeordnet ist, dass sie eine elektrische Verbindung mit der/den Lichtquelle(n) auf der Seite des Substrats ermöglicht, die der Seite, auf der die Platte angeordnet ist, gegenüberliegt.

2. Lichtquellenhalter (2; 102; 202; 302) nach Anspruch 1, **dadurch gekennzeichnet, dass** mindestens eine der Empfangsflächen (23; 123; 223; 323) allgemein parallel zur Ebene des Substrats (4; 104; 204; 304) ist.

3. Lichtquellenhalter (2; 102; 202; 302) nach einem der Ansprüche 1 oder 2, **dadurch gekennzeichnet, dass** mindestens eine der Aufnahmeflächen (23; 123; 223; 323) in Bezug auf die Ebene des Substrats (4; 104; 204; 304) geneigt ist.

4. Lichtquellenhalter (2; 102; 202; 302) nach einem der Ansprüche 1 bis 3, **dadurch gekennzeichnet, dass** das Substrat eine elektrisch isolierende Oberflächenschicht aufweist, auf der die Stromversorgungsschaltung durch elektrisch leitende metallisierte Bahnen gebildet ist.

5. Lichtquellenhalter (2; 102; 202; 302) nach einem der Ansprüche 1 bis 4, **dadurch gekennzeichnet, dass** die Öffnung (130) von mindestens einem der Metalldrähte (116) durchquert wird, die mit der Seite der Platte (110) in Kontakt mit dem Substrat (104) und mit der oder einer der Dioden (112) auf der Seite des Substrats (104) verbunden sind, die der Seite gegenüberliegt, auf der die Platte (110) angeordnet ist.

6. Lichtquellenhalter (202; 302) nach einem der Ansprüche 1 bis 4, **dadurch gekennzeichnet, dass** die Platte (210; 310) einen Abschnitt (232; 332) aufweist, der sich durch die Öffnung (230; 330) erstreckt, wobei dieser Abschnitt mindestens einen elektrischen Kontakt (218; 318) aufweist, wobei einer der Metalldrähte (216; 316) sich von diesem Kontakt zu der oder einer der Lichtquellen (212; 312) auf der Seite des Substrats (204; 304) erstreckt, die der Seite gegenüberliegt, auf der die Platte (210; 310) angeordnet ist.

7. Lichtquellenhalter (2; 102; 202; 302) nach einem der Ansprüche 1 bis 6, **dadurch gekennzeichnet, dass** das Substrat (4; 104; 204; 304) Kühlrippen (6; 106; 206; 306) aufweist.

8. Lichtquellenhalter (2; 102; 202; 302) nach Anspruch 7, **dadurch gekennzeichnet, dass** das Substrat (4; 104; 204; 304) einen ersten Abschnitt (8; 108; 208; 308), der eine die Lichtquelle(n) tragende Wand bildet, und einen zweiten Abschnitt (6; 106; 206; 306) mit den Kühlrippen umfasst.

9. Lichtquellenhalter (2; 102; 202; 302) nach einem der Ansprüche 1 bis 8, **dadurch gekennzeichnet, dass** die Lichtquelle(n) (12; 112; 212; 312) mit dem Substrat (4; 104; 204; 304) verbunden ist/sind.

10. Beleuchtungsmodul für ein Kraftfahrzeug, umfassend :
- eine Lichtquellenhalter (2; 102; 202; 302) für Lichtquelle(n) (12; 112; 212; 312) ;
- mindestens eine optische Vorrichtung, die die von der oder mindestens einer der Lichtquellen ausgesandten Lichtstrahlen in einen Beleuchtungsstrahl umlenken kann ;
darin
das Lichtquellenhalter einen der Ansprüche 1 bis 9 erfüllt.

11. Beleuchtungsmodul nach Anspruch 10, **dadurch gekennzeichnet, dass** es einen ersten Reflektor, der gegenüber einer der beiden Seiten des Substrats (4; 104; 204; 304) angeordnet ist, wobei diese Seite mindestens eine der Lichtquellen trägt, und einen zweiten Reflektor umfasst, der gegenüber der anderen der beiden Seiten angeordnet ist, wobei diese andere Seite mindestens eine der Lichtquellen trägt.

12. Beleuchtungsmodul nach einem der Ansprüche 10 und 11, **dadurch gekennzeichnet, dass** das Substrat (4; 104; 204; 304) Kühlrippen (6; 106; 206; 306) aufweist, die in Bezug auf die Hauptrichtung des Beleuchtungsstrahls hinter dem oder den Reflektoren angeordnet sind.

## Claims

1. Holder (2; 102; 202; 302) for light source(s) for a lighting and/or light signalling module for a motor vehicle, comprising :
- a substrate (4; 104; 204, 304) of thermally conductive material, preferably of metallic material, the substrate comprising a base (8; 108; 208; 308);
- at least one semiconductor light source (12; 112; 212; 312);
- a power supply circuit for the light source(s) supported by the substrate ;
- connection means (18; 118; 218; 318) to said power supply circuit (10, 29; 110; 210; 310) of the light source(s), the connection means being electrically bridged to the light source(s) (12, 112; 212; 312) by means of surface-welded metal wires (16; 116; 216; 316);
the substrate comprising at least one structure (25; 125; 225; 325) which projects from the base (8; 108; 208; 308) and which defines a receiving surface (23; 123; 223; 323) on which at least one of the light sources is arranged in thermal contact;
in which the sources are high in relation to the power supply circuit to avoid any risk of shadows being cast by the latter,
wherein the power supply circuit is printed on or in a board (10, 29; 110; 210; 310) of electrically insulating material disposed on the substrate (4; 104; 204; 304), the substrate (104; 204; 304) comprising two opposing faces, at least one of the two faces comprising the at least one structure (25; 104; 204; 304); 125; 225; 325; 27; 127) which projects from the base and which defines a receiving surface (23; 123; 223; 323) supporting at least one of the light sources (112; 212; 312), the substrate comprising an orifice (13a; 230; 330) connecting the two sides and arranged opposite the plate (110; 210; 310),
**characterized in that** the two opposite faces of the substrate each support at least one of the light sources, and **in that** the orifice (130, 230, 330) is arranged opposite the board so as to allow electrical connection with the light source(s) on the face of the substrate opposite that on which the board is arranged.

2. Support (2; 102; 202; 302) according to claim 1, **characterized in that** at least one of the receiving surfaces (23; 123; 223; 323) is generally parallel to the plane of the substrate (4; 104; 204; 304).

3. Holder (2; 102; 202; 302) according to one of claims 1 or 2, **characterized in that** at least one of the receiving surfaces (23; 123; 223; 323) is inclined with respect to the plane of the substrate (4; 104; 204; 304).

4. Holder (2; 102; 202; 302) according to one of claims 1 to 3, **characterized in that** the substrate comprises an electrically insulating surface layer, on which the power supply circuit is formed by electrically conductive metallized tracks.

5. Holder (2; 102; 202; 302) according to one of claims 1 to 4, **characterized in that** the orifice (130) is traversed by at least one of the metal wires (116) connected to the face of the plate (110) in contact with the substrate (104) and to the or one of the diodes (112) on the face of the substrate (104) opposite that on which the plate (110) is disposed.

6. Holder (202; 302) according to one of claims 1 to 4, **characterized in that** the plate (210; 310) comprises a portion (232; 332) extending through the orifice (230; 330), said portion comprising at least one electrical contact (218; 318), one of the metal wires (216; 316) extending from said contact to the or one of the light sources (212; 312) on the face of the substrate (204; 304) opposite that on which the plate (210; 310) is disposed.

7. Holder (2; 102; 202; 302) according to one of claims 1 to 6, **characterized in that** the substrate (4; 104; 204; 304) comprises cooling fins (6; 106; 206; 306).

8. Holder (2; 102; 202; 302) according to claim 7, **characterised in that** the substrate (4; 104; 204; 304) comprises a first portion (8; 108; 208; 308) forming a wall supporting the light source(s) and a second portion (6; 106; 206; 306) comprising the cooling fins.

9. Holder (2; 102; 202; 302) according to one of claims 1 to 8, **characterized in that** the light source(s) (12; 112; 212; 312) is/are bonded to the substrate (4; 104; 204; 304).

10. Lighting module for a motor vehicle, comprising :
- a holder (2; 102; 202; 302) for light source(s) (12; 112; 212; 312) ;
- at least one optical device capable of deflecting the light rays emitted by the or at least one of the light sources into an illumination beam ;
in that
the holder complies with one of claims 1 to 9.

11. Lighting module according to claim 10, **characterized in that** it comprises a first reflector arranged facing one of the two faces of the substrate (4; 104; 204; 304), said face supporting at least one of the light sources and a second reflector arranged facing the other of said two faces, said other face supporting at least one of the light sources.

12. Lighting module according to one of claims 10 and 11, **characterized in that** the substrate (4; 104; 204; 304) comprises cooling fins (6; 106; 206; 306) arranged behind the reflector or reflectors with respect to the main direction of the illumination beam.
